# EUROPEAN PATENT APPLICATION

(11) **EP 4 485 485 A1**
(43) Date of publication of application: **01.01.2025**
(21) Application number: 23918898.0
(22) Date of filing: 08.11.2023
(51) Int. Cl.: H01F 6/06

(54) **WIRE ROD GUIDE DEVICE**

(30) Priority: 09.05.2023 KR 20230059553
(71) Applicant: Maru L&C Co., Ltd., Daegu 42702 (KR)
(72) Inventor: KIM, Dongjin, Daegu 42612 (KR)
(74) Representative: Potter Clarkson
(86) International application number: PCT/KR2023/017864
(87) International publication number: WO 2024/232487

(57) **Abstract**

Provided is a wire guide device disposed in a path where a wire is moved and adjusting a conveyance direction of the wire. The device may precisely adjust the conveyance direction of the wire by conveniently and precisely adjusting the position and angle of a guide roller using an alignment unit.

## Description

### [Technical Field]

The present invention relates to a wire guide device, and more particularly, to a wire guide device disposed in a path where a wire is moved and capable of precisely adjusting a conveyance direction of the wire.

### [Background Art]

A superconductor is a material that exhibits superconductivity, and the superconductivity refers to a phenomenon where electrical resistance approaches "0" at a critical temperature or below, thus allowing an unlimited amount of a current to flow.

The superconductor may be classified into a low-temperature superconductor and a high-temperature superconductor based on the critical temperature at which the superconductivity appears, and may be classified into a metal superconductor, an oxide superconductor, an organic superconductor, or the like based on a type of a superconducting material. The oxide superconductor may have a critical temperature much higher than the metal superconductor or the organic superconductor, and is thus commonly referred to as "the high-temperature superconductor".

In general, the high-temperature superconductor may be manufactured in the form of a thin film wire, and this high-temperature superconducting wire may have better current transport capacity per unit area than the low-temperature superconductor.

The high-temperature superconducting wire may be formed through a process of depositing a buffer layer and a superconducting layer on a metal wire. The buffer layer of the superconducting wire may include several types of thin films, and the respective thin films may be formed sequentially in individual chambers by using methods such as sputtering, electron beam deposition, and the like.

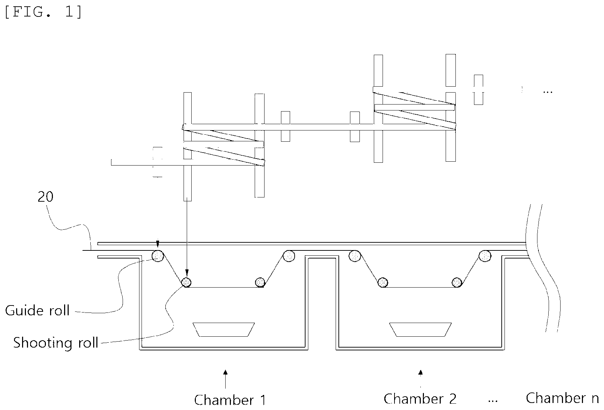

FIG. 1 is a view showing a deposition process of a superconducting wire. As shown in the drawing, various types of thin films may be sequentially deposited as the metal wire passes through n individual chambers.

Meanwhile, each chamber may be connected to each other by vacuum in order to prevent the wire from being exposed to the atmosphere during the thin film deposition, and it is very important to align the wire when taking the wire out from and inserting the same into the chamber in order to convey the wire between the chambers.

Here, an alignment error may occur while mechanically assembling the respective chambers to each other. Therefore, there is a need for a guide device which may precisely adjust a conveyance direction of the wire at an outlet and an inlet in order to align the wire by compensating for the error.

### [Disclosure]

### [Technical Problem]

An object of the present invention is to provide a wire guide device which may precisely adjust a conveyance direction of a wire by conveniently and precisely adjusting the position and angle of a guide roller using an alignment unit.

### [Technical Solution]

In one general aspect, a wire guide device, which is disposed on a path where a wire is moved and adjusts a conveyance direction of the wire, the device including: a body; an alignment unit movable by being coupled to the body; and a guide roller conveying the wire by being coupled to the alignment unit, wherein a position of the guide roller is adjusted by moving the alignment unit.

The alignment unit may include a vertical moving part and a horizontal moving part, the vertical moving part may include a vertical moving plate movable in a vertical direction, the horizontal moving part may include a horizontal moving plate movable in a horizontal direction, and the guide roller may be in conjunction with the vertical moving plate and the horizontal moving plate to be vertically moved based on the vertical movement of the vertical moving plate, and horizontally moved based on the horizontal movement of the horizontal moving plate.

The vertical moving plate may be disposed in front of the body and coupled to the body, the horizontal moving plate may be disposed in front of the vertical moving plate and coupled to the vertical moving plate, and the guide roller may be disposed in front of the horizontal moving plate and coupled to the horizontal moving plate.

The body may include a support part protruding forward from a front lower portion of the body, and the vertical moving plate may be disposed in front of the body and simultaneously disposed on the top of the support part of the body.

The vertical moving part may further include a vertical direction-adjustment screw for moving the vertical moving plate in the vertical direction, and a vertical direction-fixing screw for fixing the movement of the vertical moving plate, and the horizontal moving part may further include a horizontal direction-adjustment screw for moving the horizontal moving plate in the horizontal direction, and a horizontal direction-fixing screw for fixing the movement of the horizontal moving plate.

A screw hole may be formed in the vertical moving plate, and the vertical direction-fixing screw is installed in the screw hole of the vertical moving plate, a screw hole may be formed in the horizontal moving plate, and the horizontal direction-fixing screw is installed in the screw hole of the horizontal moving plate, the screw hole of the vertical moving plate may be formed to be long in the vertical direction, and the screw hole of the horizontal moving plate may be formed to be long in the horizontal direction.

The vertical direction-fixing screw may be coupled to the body by passing through the screw hole of the vertical moving plate, the horizontal direction-fixing screw may be coupled to the vertical moving plate by passing through the screw hole of the horizontal moving plate, and a vertical position of the horizontal moving plate may be changed in conjunction with the vertical movement of the vertical moving plate.

A slide groove may be formed in the rear of the vertical moving plate in the vertical direction, a fastening part may be disposed on the front of the body and fastened to the slide groove of the vertical moving plate, and the vertical moving plate may thus slide in the vertical direction, and a slide groove may be formed in the rear of the horizontal moving plate in the horizontal direction, a fastening part may be disposed on the front of the vertical moving plate and fastened to the slide groove of the horizontal moving plate, and the horizontal moving plate may thus slide in the horizontal direction.

A screw hole may be formed in the support part of the body and pass through the support part in the vertical direction, the vertical direction-adjustment screw may be installed by passing through the screw hole, and the vertical moving plate may be moved in the vertical direction as the vertical direction-adjustment screw is rotated.

The vertical moving plate may be seated on an end of the vertical direction-adjustment screw.

The vertical direction-adjustment screw may include a first adjustment screw and a second adjustment screw, the first adjustment screw may be disposed on a left side of the vertical moving plate based on its center in the horizontal direction, and move a left portion of the vertical moving plate in the vertical direction, the second adjustment screw may be disposed on a right side of the vertical moving plate based on its center in the horizontal direction, and move a right portion of the vertical moving plate in the vertical direction, and an angle of the guide roller may be adjusted by the vertical movement of each of the left and right portions of the vertical moving plate.

The horizontal moving part may further include a first block and a second block, the first block may be coupled and fixed to one side of the horizontal moving plate, the second block may be disposed further outside than the first block and coupled and fixed to the front of the vertical moving plate, the second block may grip the horizontal direction-adjustment screw, a screw hole may be formed in the first block and pass through the first block, the horizontal direction-adjustment screw may be installed by passing through the screw hole, the first block may be moved in the horizontal direction as the horizontal direction-adjustment screw is rotated, and the horizontal moving plate coupled to the first block may be horizontally moved in conjunction with the movement of the first block.

A manipulation means may be disposed on one side of each of the vertical direction-adjustment screw and the horizontal direction-adjustment screw to enable its manual manipulation.

The device may further include a fixing plate coupled to the body, wherein the fixing plate protrudes upward from the body, and a screw hole may be formed in an upper side of the fixing plate and pass through the fixing plate.

The fixing plate may be disposed in a center of the body in the horizontal direction, and a through hole may be formed in the fixing plate and the wire may pass through the through hole.

### [Advantageous Effects]

According to the present invention, the conveyance direction of the wire may be precisely adjusted by easily and precisely adjusting the position and angle of the guide roller using the alignment unit.

### [Description of Drawings]

FIG. 1 is a view showing a deposition process of a superconducting wire.
FIG. 2 is a perspective view of a wire guide device according to an embodiment of the present invention as viewed from an upper front side.
FIG. 3 is a perspective view of FIG. 2 as viewed from a lower front side.
FIG. 4 is a perspective view of FIG. 2 as viewed from an upper rear side.
FIG. 5 is a perspective view of FIG. 2 as viewed from a lower rear side.
FIG. 6 is an exploded perspective view of FIG. 2.
FIG. 7 is a view showing FIG. 3 again.
FIG. 8 is a view showing a body separated from FIG. 2.
FIG. 9 is a rear perspective view of the body.
FIG. 10 is a view showing a vertical moving part separated from FIG. 2.
FIG. 11 is a front perspective view of a vertical moving plate.
FIG. 12 is a rear perspective view of the vertical moving plate.
FIG. 13 is a view showing a horizontal moving part separated from FIG. 2.
FIG. 14 is a front perspective view of the horizontal moving plate.
FIG. 15 is a rear perspective view of the horizontal moving plate.
FIG. 16 is a view showing that the horizontal moving plate and the vertical moving plate are fastened to each other.
FIG. 17 is a view showing a guide roller separated from FIG. 2.
FIG. 18 is a view showing a fixing plate separated from FIG. 2.
FIG. 19 is a rear perspective view of the fixing plate.

### [Best Mode]

Hereinafter, the present invention is described with reference to the accompanying drawings.

Referring to FIG. 1 again, at least one shooting roll for transporting a wire 20 may be disposed in each chamber of a superconducting wire deposition facility, and a guide roll may be disposed between the chambers to convey and guide the wire.

A wire guide device 10 of the present invention may be a device disposed on a path along which the wire is moved and adjusting a conveyance direction of the wire. For example, the wire guide device in the present invention may correspond to the guide roll in FIG. 1, and the wire in the present invention may be a superconducting wire or a metal wire, which is its base material. Alternatively, the wire may correspond to a tape or a substrate, on which a superconducting layer is deposited.

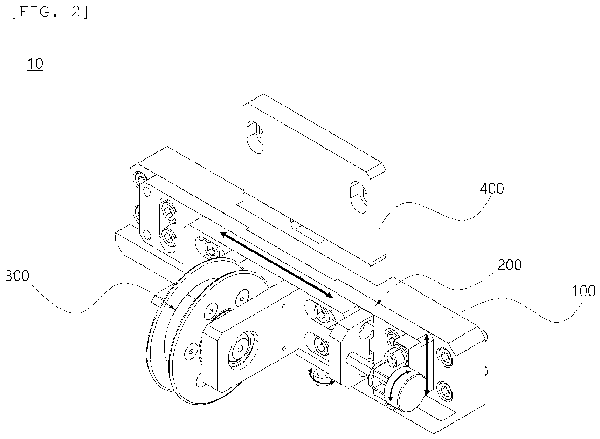

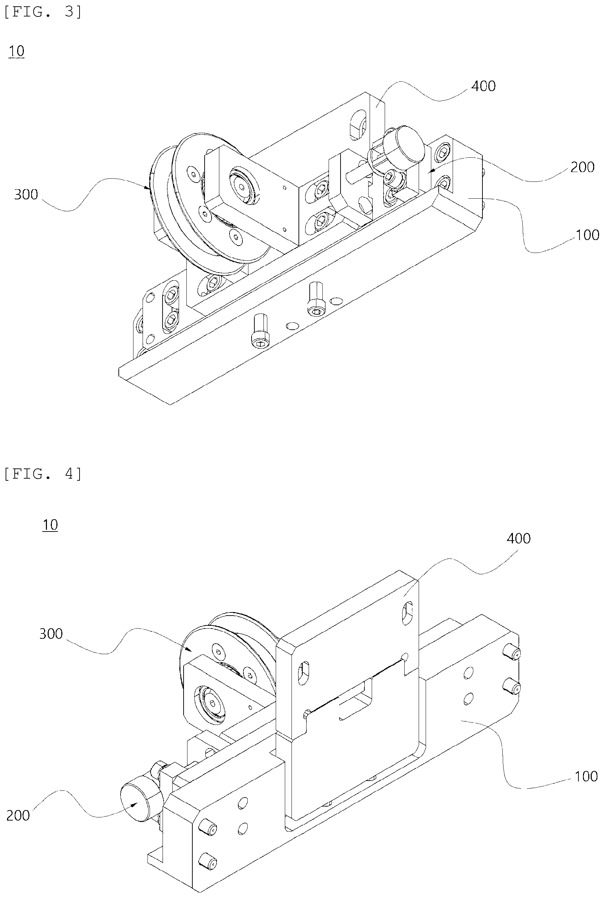

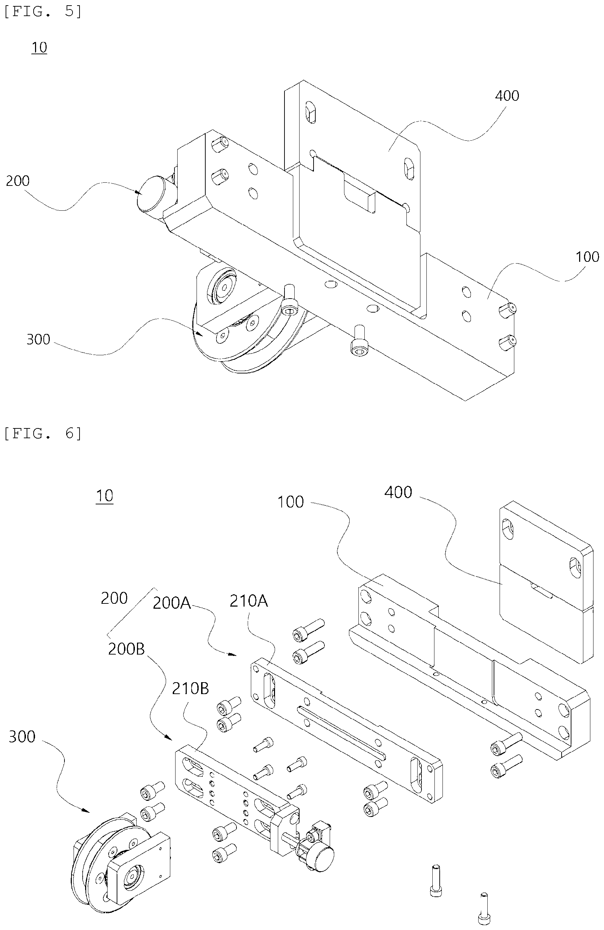

FIG. 2 is a perspective view of the wire guide device according to an embodiment of the present invention as viewed from an upper front side; FIG. 3 is a perspective view of FIG. 2 as viewed from a lower front side; FIG. 4 is a perspective view of FIG. 2 as viewed from an upper rear side; FIG. 5 is a perspective view of FIG. 2 as viewed from a lower rear side; and FIG. 6 is an exploded perspective view of FIG. 2.

As shown in the drawings, the wire guide device 10 in the present invention may largely include a body 100, an alignment unit 200, and a guide roller 300.

The body 100 may correspond to a frame on which the alignment unit 200 is installed, the alignment unit 200 may be movable by being coupled to the body 100, and the guide roller 300 may convey the wire by being coupled to the alignment unit 200.

Here, the device 10 may adjust a position of the guide roller 300 by moving the alignment unit 200. That is, the alignment unit 200 may be moved on the body, and the guide roller 300 may be coupled to the alignment unit 200 and have its position adjusted in conjunction with the movement of the alignment unit 200. Through this configuration, the conveyance direction of the wire passing through the guide roller 300 may be adjusted.

In more detail, referring to FIG. 6 again, the alignment unit 200 may include a vertical moving part 200A and a horizontal moving part 200B, the vertical moving part 200A may include a vertical moving plate 210A movable in a vertical direction, and the horizontal moving part 200B may include a horizontal moving plate 210B movable in a horizontal direction.

In addition, in the device 10, the vertical moving plate 210A may be disposed in front of the body 100, and the body 100 and the vertical moving plate 210A may be coupled to each other; the horizontal moving plate 210B may be disposed in front of the vertical moving plate 210A, and the vertical moving plate 210A and the horizontal moving plate 210B may be coupled to each other; and the guide roller 300 may be disposed in front of the horizontal moving plate 210B, and the horizontal moving plate 210B and the guide roller 300 may be coupled to each other.

Based on this structure, the guide roller 300 may be in conjunction with the vertical moving plate 210A and the horizontal moving plate 210B to be vertically moved based on the vertical movement of the vertical moving plate 210A, and horizontally moved based on the horizontal movement of the horizontal moving plate 210B. That is, as described below, the horizontal moving plate 210B coupled and fixed to the vertical moving plate 210A when the vertical moving plate 210A is vertically moved may have a position vertically changed by being in conjunction with the vertical movement of the vertical moving plate 210A; the guide roller 300 coupled and fixed to the horizontal moving plate 210B may be vertically moved as the horizontal moving plate 210B has the position vertically changed; and the guide roller 300 coupled and fixed to the horizontal moving plate 210B may be horizontally moved by being in conjunction with the horizontal movement of the horizontal moving plate 210B when the horizontal moving plate 210B is horizontally moved.

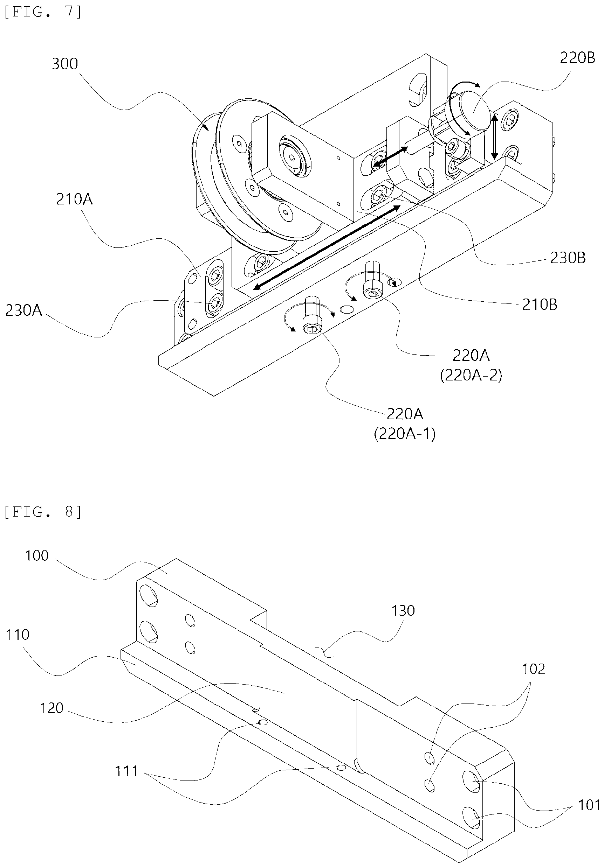

FIG. 7 is a view showing FIG. 3 again, and a brief description of an operation principle of the present invention is provided as follows.

As described above, in the device 10, the vertical moving plate 210A may be stacked in front of the body 100, the horizontal moving plate 210B may be stacked in front of the vertical moving plate 210A, and the guide roller 300 may be installed in front of the horizontal moving plate 210B. In addition, the device 10 may include an adjustment screw 220A for moving the vertical moving plate 210A, a fixing screw 230A for fixing the vertical moving plate 210A, and include an adjustment screw 220B for moving the horizontal moving plate 210B, and a fixing screw 230B for fixing the horizontal moving plate 210B. The plurality of fixing screws 230A and 230B may respectively be provided.

In this structure, a vertical position of the vertical moving plate 210A may be adjusted using the vertical moving plate-adjustment screw 220A, and the vertical moving plate 210A may be fixed using the vertical moving plate-fixing screw 230A. The horizontal moving plate 210B may be fixed to the vertical moving plate 210A, and thus be vertically moved by being in conjunction with the vertical movement of the vertical moving plate 210A, and the guide roller 300 fixed to the horizontal moving plate 210B may have a position vertically adjusted by being in conjunction with the horizontal moving plate 210B.

Here, as shown in FIG. 7, two vertical moving plate-adjustment screws 220A may be provided, and the respective screws 220A-1 and 220A-2 may be disposed on the left and right sides based on the center of the vertical moving plate 210A. Through these two adjustment screws 220A-1 and 220A-2, horizontality of the vertical moving plate 210A may be adjusted to thus ultimately adjust a horizontal angle of the guide roller 300.

Simultaneously or separately, a horizontal position of the horizontal moving plate 210B may be adjusted using the horizontal moving plate-adjustment screw 220B, and the horizontal moving plate 210B may be fixed using the horizontal moving plate-fixing screw 230B. The guide roller 300 fixed to the horizontal moving plate 210B may have a position horizontally adjusted by being in conjunction with the horizontal movement of the horizontal moving plate 210B.

In this way, in the present invention, the position and angle of the guide roller may be adjusted easily, conveniently, and precisely by stacking and disposing the two moving plates for the plates to be in conjunction with each other, fixing and coupling the guide roller to a front moving plate of the two moving plates for the guide roller to be in conjunction with the movements of the two moving plates, and using the adjustment screw to adjust the horizontal movement and the vertical movement of each of the two moving plates.

Referring to FIGS. 2 to 6 again, as described above, the present invention may include the body 100, the alignment unit 200 including the vertical moving part 200A and the horizontal moving part 200B, and the guide roller 300, and the present invention may further include a fixing plate 400. Hereinafter, the description describes each component of the present invention in more detail.

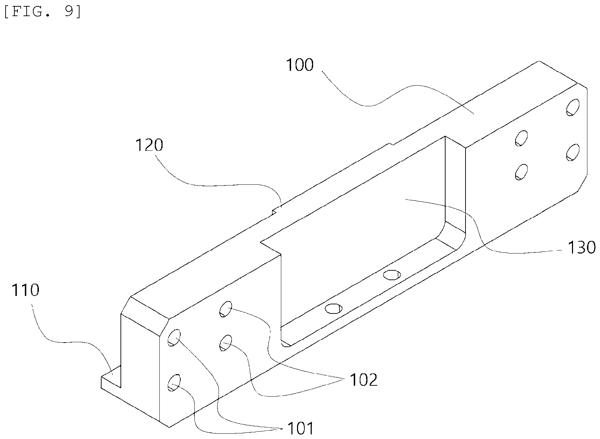

First, the description describes the body 100. FIG. 8 is a view showing the body separated from FIG. 2 and corresponds to a front perspective view of the body, and FIG. 9 corresponds to a rear perspective view of the body.

The body 100 may be the frame that supports and fixes the alignment unit 200 and the guide roller 300, and may have a plate structure extending long in the horizontal direction. A plurality of screw holes 101 may be formed in the body 100, and a screw may pass through the screw hole 101 to thus fix the body 100 to an external wall. In addition, a plurality of screw grooves 102 may be formed in the body 100, and the fixing screw 230A for fixing the vertical moving plate 210A may be inserted into the screw groove 102 to thus fix the vertical moving plate 210A onto the body 100. The screw groove 102 may be formed as a hole passing through the body 100.

As shown in FIG. 8, the body 100 may include a support part 110 protruding forward from a front lower portion of the body 100, and the vertical moving plate 210A may be disposed on the top of the support part 110. That is, the vertical moving plate 210A may be disposed in front of the body 100 and simultaneously disposed on the top of the support portion 110. This support part 110 may be a means for configuring the vertical moving part 200A. A screw hole 111 may be formed in the support part 110 and pass through the support part in the vertical direction, and the vertical direction-adjustment screw 220A may be installed by passing through the screw hole 111.

Referring to FIG. 8 again, a fastening part 120 may protrude forward to a certain extent from the front of the body 100. As described below, the fastening part 120 may be fastened to the slide groove 250A by having male and female structures with the slide groove 250A formed in the rear of the vertical moving plate 210A disposed in front of the body 100, thus assisting in sliding the vertical moving plate 210A.

In addition, referring to FIG. 9 again, a fastening groove 130 may be formed in the rear of the body 100, and the fixing plate 400 may be inserted into and fastened to the fastening groove 130. This structure may assist in preventing the fixing plate 400 from protruding rearward from the body 100, and increase a fastening force between the fixing plate 400 and the body 100.

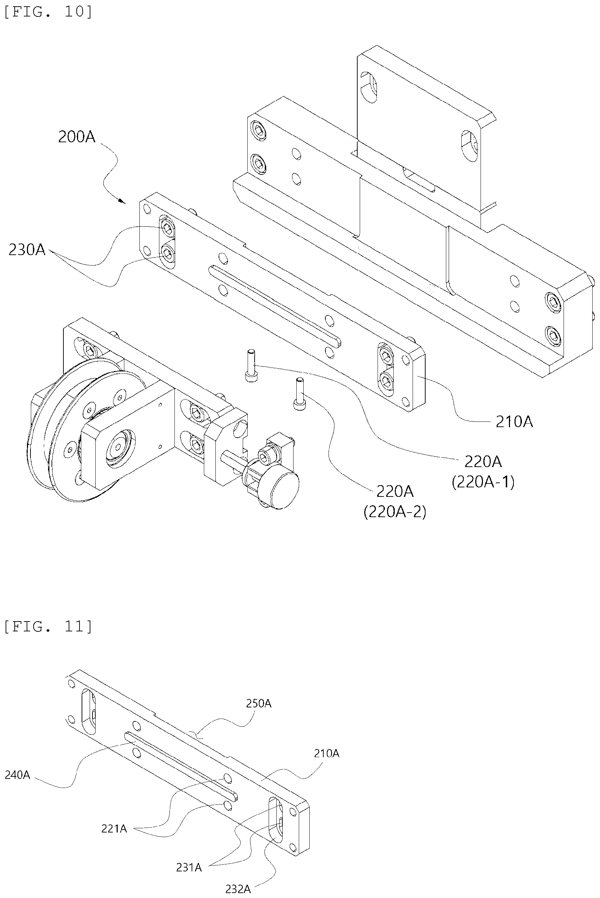

Next, the description describes the vertical moving part 200A as the alignment unit 200. FIG. 10 is a view showing the vertical moving part separated from FIG. 2, and the vertical moving part 200A may include the vertical moving plate 210A, the vertical direction-adjustment screw 220A, and the vertical direction-fixing screw 230A.

As described above, the vertical direction-adjustment screw 220A may pass through the support part 110 of the body 100. Accordingly, the vertical moving plate 210A may be seated on an end of the vertical direction-adjustment screw 220A, and the vertical moving plate 210A may be moved in the vertical direction by a rotation of the vertical direction-adjustment screw 220A. That is, when the vertical direction-adjustment screw 220A is rotated in one direction, the vertical direction-adjustment screw 220A may press the vertical moving plate 210A from the bottom to the top, and the vertical moving plate 210A may thus be moved upward, and when the vertical direction-adjustment screw 220A is rotated in the opposite direction, the vertical moving plate 210A seated on the vertical direction-adjustment screw 220A may be moved downward along the vertical direction-adjustment screw 220A.

A manipulation means may be disposed on one side of the vertical direction-adjustment screw 220A to enable its manual manipulation. For example, a head having a large diameter may be installed at the end of the vertical direction-adjustment screw 220A, and the screw 220A may thus be easily gripped by a user. Simultaneously or separately, a wrench groove may be formed in the end of the vertical direction-adjustment screw 220A for the vertical direction-adjustment screw 220A to be manipulated using the wrench groove.

Here, as described above, two adjustment screws may be provided for the vertical moving plate 210A, and the respective screws may be disposed on the left and right sides of the vertical moving plate 210A based on its center. In more detail, the vertical direction-adjustment screw 220A may include the first adjustment screw 220A-1 and the second adjustment screw 220A-2. The first adjustment screw 220A-1 may be disposed on a left side of the vertical moving plate 210A based on its center in the horizontal direction, and move a left portion of the vertical moving plate 210A in the vertical direction, and the second adjustment screw 220A-2 may be disposed on a right side of the vertical moving plate 210A based on its center in the horizontal direction, and move a right portion of the vertical moving plate 210A in the vertical direction.

Accordingly, the angle of the guide roller 300 may be adjusted by the vertical movement of each of the left and right portions of the vertical moving plate 210A. According to the present invention, it is possible to change not only the position of the guide roller 300 but also its angle, thus achieving a more precise adjustment.

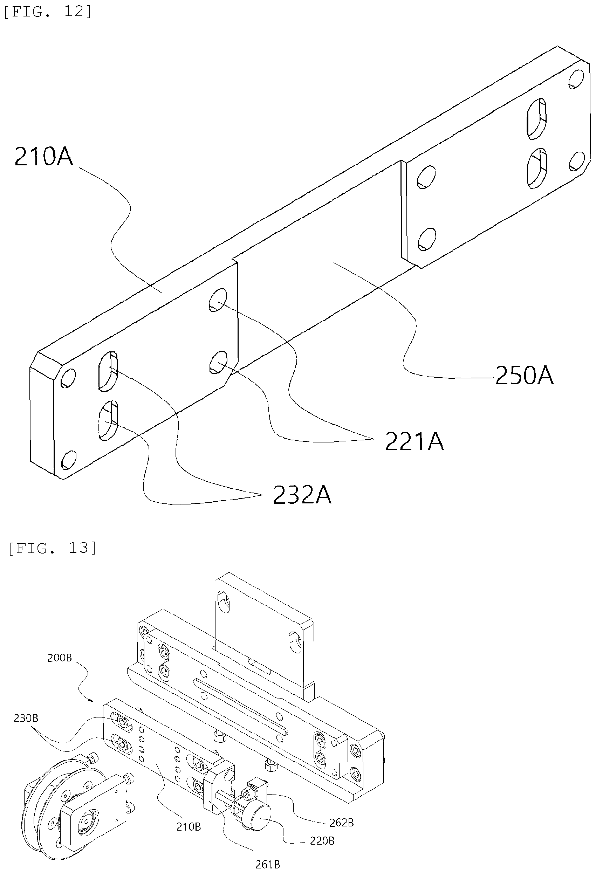

FIG. 11 is a front perspective view of the vertical moving plate and FIG. 12 is a rear perspective view of the vertical moving plate. A plurality of screw holes 231A may be formed in the vertical moving plate 210A, and the vertical direction-fixing screw 230A may be installed in the screw hole 231A. The screw hole 231A may be formed to be long in the vertical direction. A screw groove 232A may be formed in the vertical moving plate 210A, and the screw hole 231A may be formed in its center. In this structure, the vertical direction-fixing screw 230A may be fastened to the screw groove 102 of the body 100 by passing through the screw hole 231A of the vertical moving plate 210A, and the vertical moving plate 210A may thus be fixed onto the body 100.

In addition, a plurality of screw grooves 221A may be formed in the vertical moving plate 210A, and the fixing screw 220B for fixing the horizontal moving plate 210B may be inserted into the screw groove 221A to thus fix the horizontal moving plate 210B onto the vertical moving plate 210A. The screw groove 221A may be formed as a hole passing through the vertical moving plate 210A.

Referring to FIG. 11 again, a fastening part 240A may protrude forward to a certain extent from the front of the vertical moving plate 210A. As described below, the fastening part 240A may be fastened to the slide groove 220B by having male and female structures with the slide groove 220B formed in the rear of the horizontal moving plate 210B disposed in front of the vertical moving plate 210A, thus assisting in sliding the horizontal moving plate 210B.

In addition, referring to FIG. 12 again, the slide groove 250A may be formed in the rear of the vertical moving plate 210A in the vertical direction. As described above, the slide groove 250A may be fastened to the fastening part 120 by having male and female structures with the fastening part 120 formed on the front of the body 100. However, the male and female structures of the slide groove and the fastening part may be designed to be reversed as the fastening part protruding rearward is formed on the rear of the vertical moving plate 210A and the slide groove is formed in the front of the body 100.

Next, the description describes the horizontal moving part 200B as the alignment unit 200. FIG. 13 is a view showing the horizontal moving part separated from FIG. 2, and the horizontal moving part 200B may include the horizontal moving plate 210B, the horizontal direction-adjustment screw 220B, and the horizontal direction-fixing screw 230B.

In addition, the horizontal moving part 200B may include a first block 261B and a second block 261B for installing the horizontal direction-adjustment screw 220B. In more detail, as shown in the drawing, the first block 261B may be coupled and fixed to one side of the horizontal moving plate 210B, that is, a right side in the drawing, and the second block 262B may be disposed further outside than the first block 261B, that is, disposed further to the right than first block 261B in the drawing, and may be coupled and fixed to the front of the vertical moving plate 210A. The first block 261B and the horizontal moving plate 210B, or the second block 262B and the vertical moving plate 210A may be fastened to each other through the screw or the like.

The second block 262B may grip the horizontal direction-adjustment screw 220B, a screw hole may be formed in the first block 261B and pass through the first block 261B, and the horizontal direction-adjustment screw 220B may be installed by passing through the screw hole. In more detail, the second block 262B may rotatably grip the horizontal direction-adjustment screw 220B, and male and female screw threads may respectively be formed in the screw hole of the first block 261B and the horizontal direction-adjustment screw 220B.

Through this configuration, the first block 261B may be moved in the horizontal direction as the horizontal direction-adjustment screw 220B is rotated, and the horizontal moving plate 210B coupled to the first block 261B may be moved in the horizontal direction in conjunction with the movement of the first block 261B. That is, when the horizontal direction-adjustment screw 220B is rotated in one direction, the first block 261B screwed to the screw 220B may be moved to the left (or right), and the horizontal moving plate 210B coupled and fixed to the first block 261B may be moved to the left in conjunction with the movement of the first block 261B. When the horizontal direction-adjustment screw 220B is rotated in the opposite direction, the first block 261B screwed to the screw 220B may be moved to the right (or left), and the horizontal moving plate 210B coupled and fixed to the first block 261B may be moved to the right in conjunction with the movement of the first block 261B.

A manipulation means may be disposed on one side of the horizontal direction-adjustment screw 220B to enable its manual manipulation. For example, a head having a large diameter may be installed at an end of the vertical direction-adjustment screw 220B, and the screw 220B may thus be easily gripped by the user. Simultaneously or separately, a wrench groove may be formed in the end of the vertical direction-adjustment screw 220B for the vertical direction-adjustment screw 220B to be manipulated using the wrench groove.

Meanwhile, although not shown in the drawing, like the vertical direction-adjustment screws 220A described above, two horizontal direction-adjustment screws 220B may be provided, and the respective screws may be disposed on the upper and lower sides based on the center of the horizontal moving plate 210B. A design change may be made to adjust horizontality of the horizontal moving plate 210B through these two horizontal direction-adjustment screws 220B.

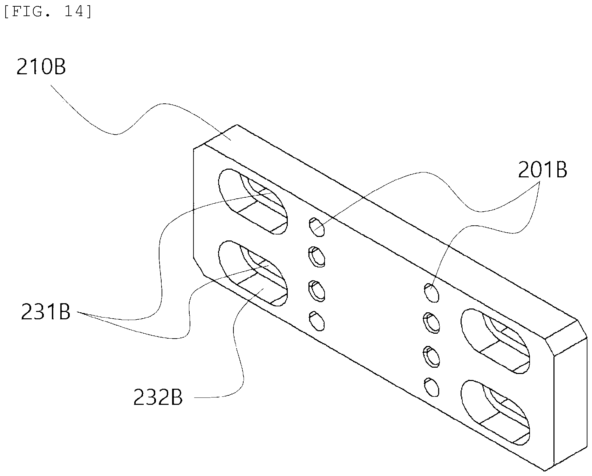

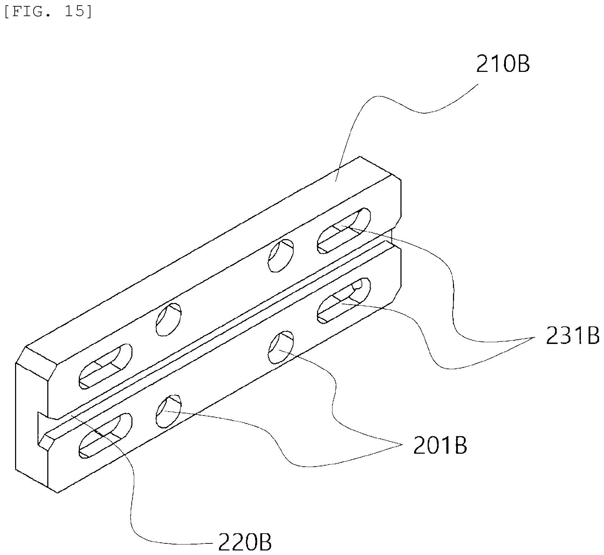

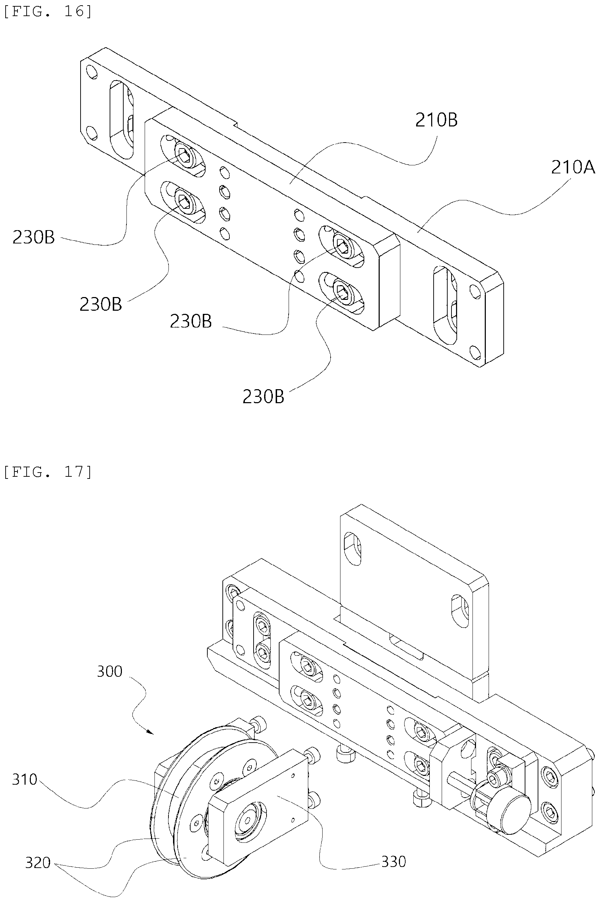

FIG. 14 is a front perspective view of the horizontal moving plate and FIG. 15 is a rear perspective view of the horizontal moving plate. A plurality of screw holes 231B may be formed in the horizontal moving plate 210B, and the horizontal direction-fixing screw 230B may be installed in the screw hole 231B. The screw hole 231B may be formed to be long in the horizontal direction. A screw groove 232B may be formed in the horizontal moving plate 210B, and the screw hole 231B may be formed in its center. In this structure, the horizontal direction-fixing screw 230B may be fastened to the screw groove of the vertical moving plate 210A by passing through the screw hole 232B of the horizontal moving plate 210B, and the horizontal moving plate 210B may thus be fixed onto the vertical moving plate 210A. FIG. 16 is a view showing that the horizontal moving plate and the vertical moving plate are fastened to each other.

Referring to FIG. 14 again, a plurality of screw grooves 201B may be formed in the horizontal moving plate 210B, and the fixing screw that fixes the guide roller 300, in more detail, a support structure 330 for supporting the guide roller 300 described below may be inserted into the screw groove, thereby fixing the guide roller 300 onto the horizontal moving plate 210B. The screw groove 201B may be formed as a hole passing through the horizontal moving plate 210B.

In addition, referring to FIG. 15 again, the slide groove 220B may be formed in the rear of the horizontal moving plate 210B in the horizontal direction. As described above, the slide groove 220B may be fastened to the fastening part 240A by having male and female structures with the fastening part 240A formed on the front of the vertical moving plate 210A. In this case as well, the male and female structures of the slide groove and the fastening part may be designed to be reversed as the fastening part protruding rearward is formed on the rear of the horizontal moving plate 210B and the slide groove is formed in the front of the vertical moving plate 210A.

Next, the description describes the guide roller 300. FIG. 17 is a view showing a guide roller separated from FIG. 2, and the guide roller 300 may correspond to an H-type guide roller including a roller 310 and a pair of guides 320. Each of the pair of guides 320 may have a disk shape, have a diameter larger than that of the roller 310, and be installed on one side or the other side of the roller 310. The guide roller 300 may be coupled and fixed to the horizontal moving plate 210B through the predetermined support structure 330.

The wire may be conveyed on the roller 310 of the guide roller 300. Here, if the movement direction of the wire and a posture of the guide roller 300, i.e., its position or angle, are not aligned, the wire may be brought into contact with the guide 320, thus damaging the wire and interfering with a wire progress. As described above, in the present invention, it is possible to adjust the position and angle of the guide roller 300 by using the alignment unit 200, that is, the vertical moving part 200A and the horizontal moving part 200B, thereby conveying the wire without friction between the wire and the guide.

The roller 310 may be manufactured using aluminum (Al) 60- or 70-series materials. Hard chrome (Cr), titanium nitride (TiN), or diamond coating may be applied to an outer peripheral surface of the roller 310 to secure hardness of a surface where the roller 310 and the wire are in contact with each other.

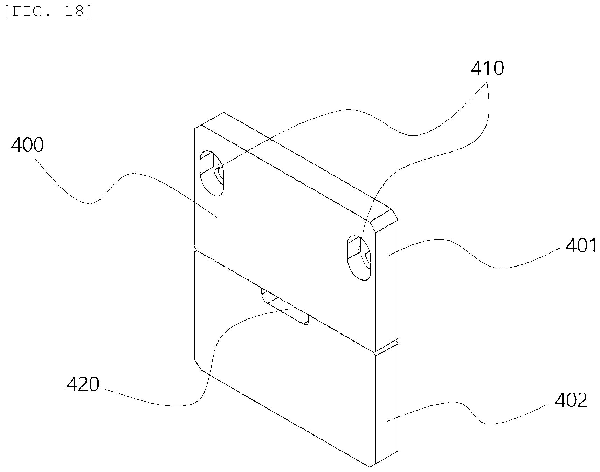

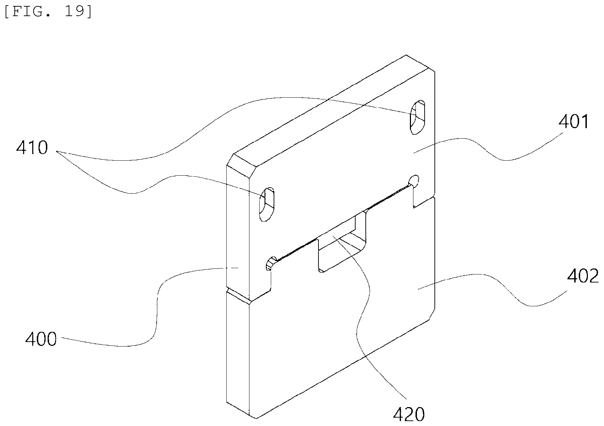

Next, the description describes the fixing plate 400. FIG. 18 is a view showing the fixing plate separated from FIG. 2 and corresponds to a front perspective view of the fixing plate, and FIG. 19 corresponds to a rear perspective view of the fixing plate.

The fixing plate 400 may be a component coupled to the body 100, and may assist in improving the fastening force on the external wall of the body 100. As described above, in the present invention, based on the body 100, the structures may be stacked in front of the body 100, and the center of gravity may be biased toward the front. Therefore, the fixing plate 400 may be further installed and the fixing plate 400 may be fixed to the wall to thus distribute a weight, thereby stably fixing the guide device 10 onto the wall.

In more detail, the fixing plate 400 may be disposed at the rear of the body 100 and protrude upward from the body 100, a screw hole 410 may be formed in an upper side of the fixing plate 400 and pass through the fixing plate 400, and a screw may pass through the screw hole 410, thereby fixing the fixing plate 400 to the wall. As described above with reference to FIG. 9, the fastening groove 130 may be formed in the rear of the body 100, and the fixing plate 400 may be inserted into the fastening groove 130, thereby fastening the fixing plate 400 to the body 100.

Referring to FIGS. 18 and 19 again, the fixing plate 400 may be disposed in the center of the body 100 in the horizontal direction, a through hole 420 may be formed in the fixing plate 400, and the wire may thus pass through the through hole 420. For example, the fixing plate 400 may be divided into an upper fixing plate 401 and a lower fixing plate 402, and the through hole 420 may be formed between the plates.

Meanwhile, referring to FIGS. 2 to 5 again, the body 100, the vertical moving plate 210A, and the horizontal moving plate 210B may have heights substantially the same as one another. A horizontal width of the vertical moving plate 210A may be smaller than a horizontal width of the body 100, and the vertical moving plate 210A may be disposed in the center of the body 100 in the horizontal direction, and a horizontal width of the horizontal moving plate 210B may be smaller than the horizontal width of the vertical moving plate 210A, and the horizontal moving plate 210B may be disposed in the center of the vertical moving plate 210A in the horizontal direction. In addition, a thickness of the fixing plate 400 may be substantially the same as a depth of the fastening groove 130 formed in the rear of the body 100, thereby preventing the rear of the fixing plate 400 from protruding further rearward than the rear of the body 100. The sizes of these components and their arrangement relationships may assist in achieving the compact configuration of the device 10 and ensuring its structural robustness.

Further, hereinabove, the description describes the present invention based on an embodiment where the vertical moving plate 210A is disposed in front of the body 100, and the horizontal moving plate 210B is disposed in front of the vertical moving plate 210A. However, the positions of the vertical moving plate 210A and the horizontal moving plate 210B may be reversed based on the operation principle of the present invention, described above.

The embodiments of the present invention have been described hereinabove with reference to the accompanying drawings. However, it is to be understood by those skilled in the art to which the present invention pertains that various modifications and alterations may be made without departing from the technical spirit or essential feature of the present invention. Therefore, it is to be understood that the embodiments described above are illustrative rather than restrictive in all aspects.

## Claims

1. A wire guide device, which is disposed on a path where a wire is moved and adjusts a conveyance direction of the wire, the device comprising:
a body;
an alignment unit movable by being coupled to the body; and
a guide roller conveying the wire by being coupled to the alignment unit, and
wherein a position of the guide roller is adjusted by moving the alignment unit.

2. The device of claim 1, wherein the alignment unit includes a vertical moving part and a horizontal moving part,
the vertical moving part includes a vertical moving plate movable in a vertical direction,
the horizontal moving part includes a horizontal moving plate movable in a horizontal direction, and
the guide roller is in conjunction with the vertical moving plate and the horizontal moving plate to be vertically moved based on the vertical movement of the vertical moving plate, and horizontally moved based on the horizontal movement of the horizontal moving plate.

3. The device of claim 2, wherein the vertical moving plate is disposed in front of the body and coupled to the body,
the horizontal moving plate is disposed in front of the vertical moving plate and coupled to the vertical moving plate, and
the guide roller is disposed in front of the horizontal moving plate and coupled to the horizontal moving plate.

4. The device of claim 3, wherein the body includes a support part protruding forward from a front lower portion of the body, and
the vertical moving plate is disposed in front of the body and simultaneously disposed on the top of the support part of the body.

5. The device of claim 4, wherein the vertical moving part further includes a vertical direction-adjustment screw for moving the vertical moving plate in the vertical direction, and a vertical direction-fixing screw for fixing the movement of the vertical moving plate, and
the horizontal moving part further includes a horizontal direction-adjustment screw for moving the horizontal moving plate in the horizontal direction, and a horizontal direction-fixing screw for fixing the movement of the horizontal moving plate.

6. The device of claim 5, wherein a screw hole is formed in the vertical moving plate, and the vertical direction-fixing screw is installed in the screw hole of the vertical moving plate,
a screw hole is formed in the horizontal moving plate, and the horizontal direction-fixing screw is installed in the screw hole of the horizontal moving plate,
the screw hole of the vertical moving plate is formed to be long in the vertical direction, and
the screw hole of the horizontal moving plate is formed to be long in the horizontal direction.

7. The device of claim 6, wherein the vertical direction-fixing screw is coupled to the body by passing through the screw hole of the vertical moving plate,
the horizontal direction-fixing screw is coupled to the vertical moving plate by passing through the screw hole of the horizontal moving plate, and
a vertical position of the horizontal moving plate is changed in conjunction with the vertical movement of the vertical moving plate.

8. The device of claim 6, wherein a slide groove is formed in the rear of the vertical moving plate in the vertical direction, a fastening part is disposed on the front of the body and fastened to the slide groove of the vertical moving plate, and the vertical moving plate thus slides in the vertical direction, and
a slide groove is formed in the rear of the horizontal moving plate in the horizontal direction, a fastening part is disposed on the front of the vertical moving plate and fastened to the slide groove of the horizontal moving plate, and the horizontal moving plate thus slides in the horizontal direction.

9. The device of claim 5, wherein a screw hole is formed in the support part of the body and passes through the support part in the vertical direction, the vertical direction-adjustment screw is installed by passing through the screw hole, and the vertical moving plate is moved in the vertical direction as the vertical direction-adjustment screw is rotated.

10. The device of claim 9, wherein the vertical moving plate is seated on an end of the vertical direction-adjustment screw.

11. The device of claim 9, wherein the vertical direction-adjustment screw includes a first adjustment screw and a second adjustment screw,
the first adjustment screw is disposed on a left side of the vertical moving plate based on its center in the horizontal direction, and moves a left portion of the vertical moving plate in the vertical direction,
the second adjustment screw is disposed on a right side of the vertical moving plate based on its center in the horizontal direction, and moves a right portion of the vertical moving plate in the vertical direction, and
an angle of the guide roller is adjusted by the vertical movement of each of the left and right portions of the vertical moving plate.

12. The device of claim 5, wherein the horizontal moving part further includes a first block and a second block,
the first block is coupled and fixed to one side of the horizontal moving plate,
the second block is disposed further outside than the first block and coupled and fixed to the front of the vertical moving plate,
the second block grips the horizontal direction-adjustment screw,
a screw hole is formed in the first block and passes through the first block,
the horizontal direction-adjustment screw is installed by passing through the screw hole,
the first block is moved in the horizontal direction as the horizontal direction-adjustment screw is rotated, and
the horizontal moving plate coupled to the first block is horizontally moved in conjunction with the movement of the first block.

13. The device of claim 12, wherein a manipulation means is disposed on one side of each of the vertical direction-adjustment screw and the horizontal direction-adjustment screw to enable its manual manipulation.

14. The device of claim 1, further comprising a fixing plate coupled to the body,
wherein the fixing plate protrudes upward from the body, and
a screw hole is formed in an upper side of the fixing plate and passes through the fixing plate.

15. The device of claim 14, wherein the fixing plate is disposed in a center of the body in the horizontal direction, and
a through hole is formed in the fixing plate and the wire passes through the through hole.
